## Europäisches Patentamt

## European Patent Office

## Office européen des brevets

(19)

(11) Veröffentlichungsnummer: **0 208 260**
**B1**

(12) **EUROPÄISCHE PATENTSCHRIFT**

(45) Veröffentlichungstag der Patentschrift:
**29.08.90**

(21) Anmeldenummer: **86109055.3**

(22) Anmeldetag: **03.07.86**

(51) Int. Cl.⁵: **H05K 7/14**

(54) **Vorrichtung zum Befestigen von Baugruppenträgern in Schaltschränken.**

(30) Priorität: **09.07.85 DE 3524400**

(43) Veröffentlichungstag der Anmeldung:
**14.01.87 Patentblatt 87/3**

(45) Bekanntmachung des Hinweises auf die Patenterteilung:
**29.08.90 Patentblatt 90/35**

(84) Benannte Vertragsstaaten:
**AT BE CH FR GB IT LI LU NL SE**

(56) Entgegenhaltungen:
**DE-A- 1 465 218**
**DE-B- 1 131 748**
**FR-A- 2 344 734**

(73) Patentinhaber: **Rittal-Werk Rudolf Loh GmbH & Co. KG,
Auf dem Stützelberg, D-6348 Herborn(DE)**

(72) Erfinder: **Bovermann, Klaus-Dieter, Am Oberg 7,
D-3565 Niederdieten(DE)**

(74) Vertreter: **Vogel, Georg, Pat.-Ing. Georg Vogel
Hermann-Essig-Strasse 35,
D-7141 Schwieberdingen(DE)**

## Beschreibung

Die Erfindung betrifft eine Vorrichtung zum Befestigen von Baugruppenträgern an den vertikalen Rahmenschenkeln der Vorderseite eines Schaltschrankes, bei der mit Gewindeaufnahmen versehene Gerätehalter mit den Rahmenschenkeln so verbindbar sind, daß daran die Frontplatten der Baugruppenträger anschraubbar sind.

Bei den bekannten Vorrichtungen dieser Art sind die Gerätehalter als Winkel ausgebildet, die in einem Schenkel die Gewindeaufnahme zum Anschrauben der Frontplatte des Baugruppenträgers aufweisen und im anderen Schenkel eine Bohrung für eine Befestigungsschraube haben, mit der der Winkel an dem Rahmenschenkel befestigt wird. Der Rahmenschenkel weist eine durchgehende T-Nut auf, in die Streifen mit im Abstand angeordneten Gewindebohrungen eingeschoben sind.

Diese bekannte Vorrichtung hat den Vorteil, daß zwischen den Winkeln genügend Platz besteht, um den Baugruppenträger mittels eines Teleskopauszuges mit dem Schaltschrank zu verbinden, so daß er nach dem Lösen der die Frontplatte mit den Winkeln verbindenden Befestigungsschrauben aus dem Schaltschrank herausgezogen werden kann. Da die Streifen mit den Gewindebohrungen die Rasterung fest vorgeben, können die vertikalen Abstände der Baugruppenträger im Schaltschrank nicht variiert werden und sind daher fest vorgegeben.

Es ist auch eine Vorrichtung bekannt, bei der in die durchgehende T-Nut der Rahmenschenkel speziell ausgebildete Muttern einsetzbar sind. Diese Spezialmuttern sind senkrecht zur T-Nut einsetzbar und halten sich von selbst mittels einer Feder in der T-Nut, um das Einschrauben einer Befestigungsschraube zu erleichtern.

Mit dieser bekannten Vorrichtung kann der vertikale Abstand der Baugruppenträger im Schaltschrank kontinuierlich verändert werden. Zwischen den Befestigungsstellen an den Rahmenschenkeln ist aber kein Platz zum Herausführen einer Teleskopschiene. Die Baugruppenträger können daher nicht mittels Teleskopauszügen im Schaltschrank befestigt werden.

Es ist Aufgabe der Erfindung, eine Vorrichtung der eingangs erwähnten Art zu schaffen, mit der der vertikale Abstand der Baugruppenträger im Schaltschrank kontinuierlich verändert werden kann, aber die Möglichkeit läßt, die Baugruppenträger auch mittels Teleskopauszügen im Schaltschrank zu befestigen.

Diese Aufgabe wird nach der Erfindung dadurch gelöst, daß an den beiden Rahmenschenkeln der Vorderseite des Schaltschrankes Verbindungsleisten angebracht sind, die mit einem parallel zur Vorderseite ausgerichteten, vertikalen Verbindungssteg gegeneinander gerichtet sind und daß auf diese Verbindungsstege senkrecht zu ihrer Längsrichtung als Gerätehalter mit einer Gewindeaufnahme versehene Gleitstücke aufbringbar und in beliebiger Stellung daran festlegbar sind.

Die Gleitstücke können an beliebigen Stellen der Verbindungsstege der Verbindungsleisten befestigt werden, so daß jeder beliebige vertikale Abstand zwischen den Baugruppenträgern eingestellt werden kann. Zwischen den Gleitstücken bleibt aber genügend Platz, einen Teleskopauszug aus dem Schaltschrank herauszuführen. Der Teleskopauszug liegt zwischen den beiden Gleitstücken, die auf jeder Seite zur Befestigung eines Baugruppenträgers verwendet werden.

Zur Anbringung der Verbindungsleisten an den vertikalen Rahmenschenkeln des Schaltschrankes sieht eine Ausgestaltung vor, daß die Verbindungsleisten entlang einer Längskante mit einem abgewinkelten Flansch versehen und mit der Rückseite der vertikalen Rahmenschenkel des Schaltschrankes verbunden sind. Der Verbindungssteg ist daher auf der dem Flansch abgekehrten Seite der Verbindungsleiste angeformt.

Das Anlegen der Verbindungsleiste an den Rahmenschenkel wird dabei dadurch erleichtert, daß die Verbindungsleiste mit einem Anlagesteg über den Flansch hinaus verlängert ist.

Nach einer Ausgestaltung ist vorgesehen, daß der Verbindungssteg in einen U-förmigen Steg übergeht, dessen einer Seitenschenkel mit der Verbindungsleiste verbunden ist, daß der U-förmige Steg mit seiner offenen Seite gegen die Verbindungsleiste gerichtet ist und daß der Verbindungssteg auf der Außenseite des Mittelschenkels dieses U-förmigen Steges angeformt ist. Damit erhält der Verbindungssteg einen ausreichenden Abstand zum Rahmenschenkel.

Ist nach einer weiteren Ausgestaltung vorgesehen, daß der Verbindungssteg auf mindestens einer parallel zur Vorderseite des Schaltschrankes ausgerichteten Seitenwand mit einer Aufnahmenut für Halteansätze der Gleitstücke versehen ist, dann wird der Halt der Gleitstücke an dem Verbindungssteg wesentlich verbessert.

Damit die Gleitstücke an beliebigen Stellen auf dem Verbindungssteg senkrecht zu dessen Längsachse aufgebracht werden können, sieht eine Ausgestaltung vor, daß die Gleitstücke aus zwei plattenförmigen Teilen bestehen, von denen das eine Teil mit der Gewindeaufnahme und das andere Teil mit einer Bohrung für die Befestigungsschraube versehen sind, daß mittels der Befestigungsschraube die Frontplatte des Baugruppenträgers mit den beiden, den Verbindungssteg umschließenden Teilen des Gleitstückes verbindbar ist und daß dabei die beiden Teile des Gleitstückes gleichzeitig an dem Verbindungssteg festlegbar sind, wobei der Halteansatz des einen Teiles des Gleitstückes dieses nicht abziehbar an dem Verbindungssteg festhält.

Die Montage läßt sich nach einer Ausgestaltung dadurch vereinfachen, daß die Gleitstücke als U-förmige Steckteile ausgebildet sind, wobei der Steckschlitz senkrecht zu der in einem Schenkel angebrachten Gewindeaufnahme steht und der andere Schenkel mit einer fluchtenden Bohrung für die Befestigungsschraube versehen ist. Dabei ist vorgesehen, daß ein Schenkel des Steckteiles federnd ausgebildet ist, und auf seiner Innenseite den Halteansatz zum Eingreifen in die Aufnahmenut des Verbindungssteges trägt, um eine Art Rastverbindung zu erhalten, die das aufgesteckte Gleitstück schon am Verbindungssteg festhält, was das Einführen der Befestigungsschraube erleichtert.

Ist nach einer Ausgestaltung vorgesehen, daß die dem Flansch abgekehrte Längskante der Verbindungsleiste in einen weiteren Verbindungssteg ausläuft, der senkrecht zur Vorderseite des Schaltschrankes steht, dann wird mit der Verbindungsleiste eine weitere Verbindungsebene geschaffen, die z.B. für die Befestigung des Teleskopauszuges verwendet werden kann. Damit diese Befestigung den Auszug des Baugruppenträgers nicht beeinträchtigt, sieht eine weitere Ausgestaltung vor, daß der weitere Verbindungssteg an einem U-förmigen Steg so angebracht ist, daß die aufgesteckten und daran festgelegten Gleitstücke bündig mit der der anderen Verbindungsleiste zugekehrten Innenseite abschließen.

Der frontseitige Abschluß der Baugruppenträger mit der Verbindungsleiste wird dabei so ausgeführt, daß der mit dem U-förmigen Steg verbundene Verbindungssteg so in Richtung des Schrankinneren versetzt ist, daß die Frontplatte des Baugruppenträgers bündig mit dem angrenzenden und mit einem Absatz für die Frontplatte versehenen Schenkel des U-förmigen Steges abschließt.

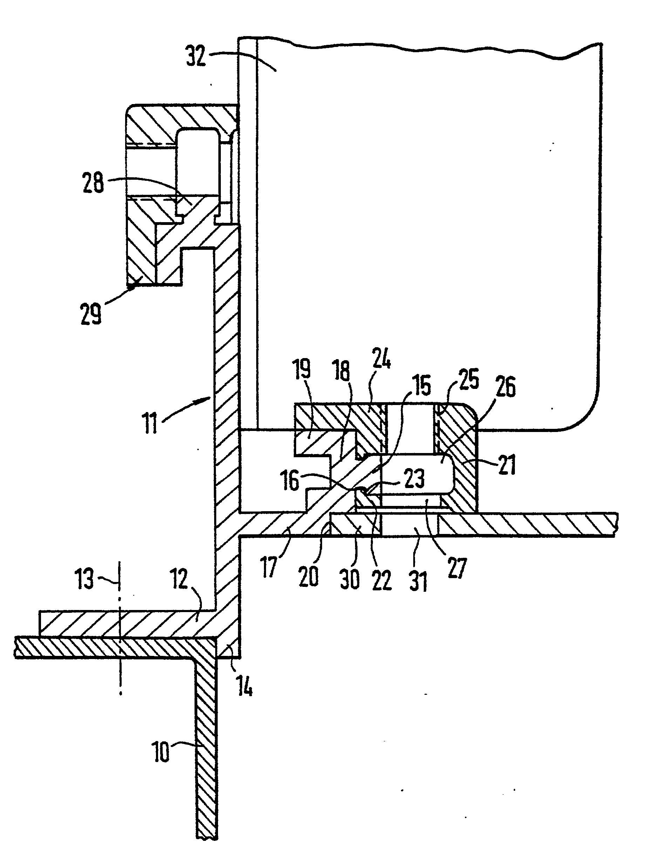

Die Erfindung wird anhand eines in der Zeichnung im Schnitt dargestellten Ausführungsbeispiels näher erläutert. Der Schnitt zeigt die an einem vertikalen Rahmenschenkel 10 angebrachte Verbindungsleiste 11, die an der unteren Längskante mit dem Flansch 12 versehen ist. Der Rahmenschenkel 10 trägt an der Rückseite eine durchgehende Lochreihe, so daß der Flansch 12 mit dem Rahmenschenkel an mehreren Stellen verschraubt werden kann, wie die Verbindung 13 andeutet. Die Längskante der Verbindungsleiste 11 ist über den Flansch 12 hinaus als Anlagesteg 14 verlängert, der das Ansetzen an den Rahmenschenkel 10 erleichtert.

Auf der dem Flansch 12 abgekehrten Seite trägt die Verbindungsleiste 11 den angeformten Verbindungssteg 15, der parallel zur Vorderseite ausgerichtet ist. Am gegenüberliegenden vertikalen Rahmenschenkel der Vorderseite des Schaltschrankes ist eine gleiche Verbindungsleiste 11 angebracht, die mit ihrem Verbindungssteg 15 in derselben Ebene liegt und gegen den Verbindungssteg 15 der anderen Verbindungsleiste 11 weist.

Der Verbindungssteg 15 ist an der Außenseite des Mittelschenkels 18 des U-förmigen Steges angebracht, der mit den Seitenschenkeln 17 und 19 vervollständigt wird. Der Seitenschenkel 17 ist außen mit dem Absatz 20 für die Frontplatte 30 des Baugruppenträgers 32 versehen und ist einstückig an der Verbindungsleiste 11 angeformt. Die parallel zur Vorderseite des Schaltschrankes stehende vordere Seitenwand des Verbindungssteges 15 trägt die durchgehende Aufnahmenut 16 für den Halteansatz 23 des als Gleitstück 21 ausgebildeten Gerätehalters. Das Gleitstück 21 ist durch den Querschlitz 26 in die beiden Schenkel 22 und 24 unterteilt, wobei im Schenkel 22 die Bohrung 27 für die Befestigungsschraube angeordnet ist. Die Befestigungsschraube wird durch die Bohrung 31 der Frontplatte 30 und die Bohrung 27 im Schenkel 22 des Gleitstückes 21 eingeführt und dann in die Gewindeaufnahme 25 des Schenkels 24 eingeschraubt. Da der Schenkel 22 federnd ausgebildet ist, kann das Gleitstück 21 senkrecht zu dem Verbindungssteg 15 auf diesen aufgerastet werden, wobei der Schenkel 22 so weit ausgelenkt wird, daß der Halteansatz 23 in die Aufnahmenut 16 einrasten kann. Die Rastverbindung ist dabei so, daß das Gleitstück 21 an dem Verbindungssteg 15 gehalten ist und nicht nach unten rutscht. Wird die Befestigungsschraube in die Gewindeaufnahme 25 eingeschraubt, dann hält die am Absatz des Schenkels 17 aufliegende Frontplatte 30 den Schenkel 22 am Verbindungssteg 15 und der Schenkel 24 wird gegen den Verbindungssteg 15 gezogen und daran verspannt, so daß das Gleitstück 21 axial unverschiebbar an dem Verbindungssteg 15 gehalten ist. Da der Halteansatz 23 fest in der Aufnahmenut 16 sitzt, kann das Gleitstück 21 auch nicht parallel zur Frontplatte 30 von dem Verbindungssteg 15 abgezogen werden.

Dieselbe Wirkung läßt sich auch mit einem zweiteiligen Gleitstück 21 erreichen, das im Bereich des Querschlitzes 26 in zwei plattenförmige Teile unterteilt ist, die an die Seitenwände des Verbindungssteges 15 angelegt und mittels der Befestigungsschraube daran gehalten sind. Das den Schenkel 22 bildende Teil trägt auf der Innenseite wieder den Halteansatz 23.

Der Verbindungssteg 15 an dem U-förmigen Teil aus den Seitenschenkeln 17 und 19, sowie dem Mittelschenkel 18 ist gegenüber dem Rahmenschenkel 10 zum Schrankinneren und in Richtung zum gegenüberliegenden Rahmenschenkel versetzt. Ist ein Baugruppenträger im unteren und oberen Bereich seiner Frontplatte 30 an einem Gleitstück 21 befestigt, so verbleibt zwischen diesen beiden Gleitstücken 21, d.h. zwischen den einander zugekehrten Verbindungsstegen 15, genügend Platz, um einen Teleskopauszug so an der Verbindungsleiste 11 zu befestigen, daß diese zwischen deren beiden Gleitstücken 21 ausgezogen werden kann. Dazu kann die hintere Längskante der Verbindungsleiste 11 selbst wieder als Verbindungssteg 28 ausgebildet sein, der an einem U-förmigen Steg angebracht mit der Verbindungsleiste 11 einstückig ausgebildet ist. Auf diesen Verbindungssteg 28 können Gleitstücke 29 in gleicher Weise aufgesteckt und festgelegt werden. Der Verbindungssteg 28 ist identisch ausgelegt wie der Verbindungssteg 15, so daß auch die Gleitstücke 21 und 29 identisch ausgebildet sein können. Der Verbindungssteg 28 ist soweit von der Innenseite der Verbindungsleiste 11 mit dem Verbindungssteg 15 versetzt, daß das Gleitstück 29 mit seinem federnden Schenkel bündig mit dieser Innenseite abschließt.

Der U-förmige Steg mit den Seitenschenkeln 17 und 19 sowie dem Mittelschenkel 18 bestimmt durch seine Stellung im Bezug auf den Flansch 12 die Lage der Frontplatte 30 des Baugruppenträgers im Schaltschrank. Der Absatz 20 am Seitenschenkel 17 ist so ausgelegt, daß die Frontplatte 30 bündig mit dem Seitenschenkel 17 abschließt. Anstelle der Frontplatte 30 kann der Baugruppenträger mit seitlichen Befestigungsflanschen versehen sein, die dann wie die Frontplatte 30 des Ausführungsbeispiels befestigt werden. Der Baugruppenträger ruht beim Ausführungsbeispiel auf der Gleitschiene 32, die mittels des Gleitstückes 29 am Verbindungssteg 28 der Verbindungsleiste 11 angebracht ist.

**Patentansprüche**

1. Vorrichtung zum Befestigen von Baugruppenträgern an den vertikalen Rahmenschenkeln der Vorderseite eines Schaltschrankes, bei der mit Gewindeaufnahmen versehene Gerätehalter mit den Rahmenschenkeln so verbindbar sind, daß daran die Frontplatten der Baugruppenträger anschraubbar sind,
dadurch gekennzeichnet,
daß an den beiden Rahmenschenkeln (10) der Vorderseite des Schaltschrankes Verbindungsleisten (11) angebracht sind, die mit einem parallel zur Vorderseite ausgerichteten, vertikalen Verbindungssteg (15) gegeneinander gerichtet sind und
daß auf diese Verbindungsstege (15) senkrecht zu ihrer Längsrichtung als Gerätehalter mit einer Gewindeaufnahme (25) versehene Gleitstücke (21) aufbringbar und in beliebiger Stellung daran festlegbar sind.

2. Vorrichtung nach Anspruch 1,
dadurch gekennzeichnet,
daß die Verbindungsleisten (11) entlang einer Längskante mit einem abgewinkelten Flansch (12) versehen und mit der Rückseite der vertikalen Rahmenschenkel (10) des Schaltschrankes verbunden sind.

3. Vorrichtung nach Anspruch 1 oder 2,
dadurch gekennzeichnet,
daß der Verbindungssteg (15) auf der dem Flansch (12) abgekehrten Seite der Verbindungsleiste (11) angeformt ist.

4. Vorrichtung nach einem der Ansprüche 1 bis 3,
dadurch gekennzeichnet,
daß die Verbindungsleiste (11) mit einem Anlagesteg (14) über den Flansch (12) hinaus verlängert ist.

5. Vorrichtung nach einem der Ansprüche 1 bis 4,
dadurch gekennzeichnet,
daß der Verbindungssteg (15) in einen U-förmigen Steg übergeht, dessen einer Seitenschenkel (17) mit der Verbindungsleiste (11) verbunden ist.

6. Vorrichtung nach Anspruch 5,
dadurch gekennzeichnet,
daß der U-förmige Steg mit seiner offenen Seite gegen die Verbindungsleiste (11) gerichtet ist und daß der Verbindungssteg (15) auf der Außenseite des Mittelschenkels (18) dieses U-förmigen Steges angeformt ist.

7. Vorrichtung nach einem der Ansprüche 1 bis 6,
dadurch gekennzeichnet,
daß der Verbindungssteg (15) auf mindestens einer parallel zur Vorderseite des Schaltschrankes ausgerichteten Seitenwand mit einer Aufnahmenut (16) für Halteansätze (23) der Gleitstücke (21) versehen ist.

8. Vorrichtung nach einem der Ansprüche 1 bis 7,
dadurch gekennzeichnet,
daß die Gleitstücke (21) aus zwei plattenförmigen Teilen bestehen, von denen das eine Teil mit der Gewindeaufnahme (25) und das andere Teil mit einer Bohrung (27) für die Befestigungsschraube versehen sind,
daß mittels der Befestigungsschraube die Frontplatte des Baugruppenträgers mit den beiden, den Verbindungssteg (15) umschließenden Teilen des Gleitstückes (21) verbindbar ist und
daß dabei die beiden Teile des Gleitstückes (21) gleichzeitig an dem Verbindungssteg (15) festlegbar sind, wobei der Halteansatz (23) des einen Teiles des Gleitstückes (21) dieses nicht abziehbar an dem Verbindungssteg (15) festhält.

9. Vorrichtung nach einem der Ansprüche 1 bis 7,
dadurch gekennzeichnet,
daß die Gleitstücke (21) als U-förmige Steckteile ausgebildet sind, wobei der Steckschlitz (26) senkrecht zu der in einem Schenkel (24) eingebrachten Gewindeaufnahme (25) steht und der andere Schenkel (22) mit einer fluchtenden Bohrung (27) für die Befestigungsschraube versehen ist.

10. Vorrichtung nach Anspruch 9,
dadurch gekennzeichnet,
daß ein Schenkel (27) des Steckteiles federnd ausgebildet ist und auf seiner Innenseite den Halteansatz (23) zum Eingreifen in die Aufnahmenut (16) des Verbindungssteges (15) trägt.

11. Vorrichtung nach einem der Ansprüche 1 bis 10,
dadurch gekennzeichnet,
daß die dem Flansch (12) abgekehrte Längskante der Verbindungsleiste (11) in einen weiteren Verbindungssteg (28) ausläuft, der senkrecht zur Vorderseite des Schaltschrankes steht.

12. Vorrichtung nach Anspruch 11,
dadurch gekennzeichnet,
daß der weitere Verbindungssteg (28) an einem U-förmigen Steg so angebracht ist, daß die aufgesteckten und daran festgelegten Gleitstücke (29) bündig mit der der anderen Verbindungsleiste (11) zugekehrten Innenseite abschließen.

13. Vorrichtung nach einem der Ansprüche 1 bis 12,
dadurch gekennzeichnet,
daß der mit dem U-förmigen Steg verbundene Verbindungssteg (15) so in Richtung des Schrankinneren versetzt ist, daß die Frontplatte (30) des Baugruppenträgers bündig mit dem angrenzenden und mit einem Absatz (20) für die Frontplatte (30) versehenen Schenkel (17) des U-förmigen Steges abschließt.

**Claims**

1. Apparatus for securing assembly carriers on the vertical frame portions of the front end of a switchgear cabinet, wherein equipment holders, which are provided with threaded receiving means, are connectable to the frame portions in such a manner that the front plates of the assembly carriers are screw-connectable thereto, characterised in that connecting bars (11) are mounted on the two frame portions (10) of the front end of the switchgear cabinet and are orientated towards one another with a vertical connecting web (15), which extends parallel to the front end, and in that sliding members (21), which are provided with a threaded receiving means (25), are attachable, as equipment holders, to these connecting webs (15) at right angles to their longitudinal direction and are securable thereto in any desired position.

2. Apparatus according to claim 1, characterised in that the connecting bars (11) are provided with a bent-over flange (12) along one longitudinal edge and are connected to the rear end of the vertical frame portions (10) of the switchgear cabinet.

3. Apparatus according to claim 1 or 2, characterised in that the connecting web (15) is shaped to fit on the side of the connecting bar (11) remote from the flange (12).

4. Apparatus according to one of claims 1 to 3, characterised in that the connecting bar (11) extends beyond the flange (12) by one abutment web (14).

5. Apparatus according to one of claims 1 to 4, characterised in that the connecting web (15) develops into a U-shaped web, one lateral portion (17) of which is connected to the connecting bar (11).

6. Apparatus according to claim 5, characterised in that the U-shaped web is orientated with its open side towards the connecting bar (11), and in that the connecting web (15) is shaped to fit on the outside of the central portion (18) of this U-shaped web.

7. Apparatus according to one of claims 1 to 6, characterised in that the connecting web (15) is provided with a receiving groove (16) for receiving retaining extension portions (23) of the sliding members (21).

8. Apparatus according to one of claims 1 to 7, characterised in that the sliding members (21) comprise two plate-like portions, of which one portion is provided with the threaded receiving means (25) and the other portion is provided with a bore (27) for the securing screw, in that the front plate of the assembly carrier is connectable, by means of the securing screw, to the two portions of the sliding member (21) which surround the connecting web (15), and in that the two portions of the sliding member (21) are thereby simultaneously securable to the connecting web (15), the retaining extension member (23) of one portion of the sliding member (21) securing said sliding member to the connecting web (15) in a non-detachable manner.

9. Apparatus according to one of claims 1 to 7, characterised in that the sliding members (21) are U-shaped plug-in component parts, the plug-in slot (26) extending at right angles to the threaded receiving means (25), which is provided in a leg portion (24), and the other leg portion (22) is provided with an aligned bore (27) for accommodating the securing screw.

10. Apparatus according to claim 9, characterised in that a leg portion (22) of the plug-in component part is adapted to be resilient and has, on its inside, the retaining extension portion (23) for engaging in the receiving groove (16) of the connecting web (15).

11. Apparatus according to one of claims 1 to 10, characterised in that the longitudinal edge of the connecting bar (11) remote from the flange (12) develops into an additional connecting web (28) which extends at right angles to the front end of the switchgear cabinet.

12. Apparatus according to claim 11, characterised in that the additional connecting web (28) is provided on a U-shaped web in such a manner that the sliding members (29), which are mounted thereon and secured thereto, terminate flush with the inside facing the other connecting bar (11).

13. Apparatus according to one of claims 1 to 12, characterised in that the connecting web (15), which is connected to the U-shaped web, is offset in the direction of the cabinet interior in such a manner that the front plate (30) of the assembly carrier terminates flush with the adjacent portion (17) of the U-shaped web, which portion is provided with a shoulder portion (20) for the front plate (30).

**Revendications**

1. Dispositif pour la fixation des châssis équipes aux parties du cadre verticales du devant d'une armoire de distribution, avec lequel on peut joindre des teneurs d'appareil munis de logements du filetage avec les parties du cadre de manière que les panneaux de front des châssis équipes peuvent être y fixés avec des vis, caractérisé par le fait que sur les deux parties du cadre (10) du front de l'armoire de distribution, il y a des listeaux de raccord (11), qui sont arrangés l'un envers l'autre avec une âme de raccord verticale (15) qui est alignée parallèlement au front et et qu'il est possible d'installer sur ces âmes de raccord (15), perpendiculairement sur leur sens longitudinal, des pièces coulissantes (21) munies d'un logement de filetage (25), comme teneurs d'appareils, et de les y visser dans une position quelconque.

2. Dispositif selon revendication 1, caractérisé par le fait que les listeaux de raccord (11) sont, le long d'une arête longitudinale, munis d'une bride (12) à déplacement angulaire et joints avec le derrière des parties du cadre verticales (10) de l'armoire de distribution.

3. Dispositif selon revendication 1 ou 2, caractérisé par le fait que l'âme de raccord (15) est formée au listeau de raccord (11) au côté détourné de la bride (12).

4. Dispositif selon une des revendications 1 à 3, caractérisé par le fait que le listeau de raccord (11) est allongé au-delà de la bride (12) avec une âme d'appui (14).

5. Dispositif selon une des revendications 1 à 4, caractérisé par le fait que l'âme de raccord (15) mène à une âme en forme d'U, un partie (17) de laquelle est reliée avec le listeau de raccord (11).

6. Dispositif selon revendication 5, caractérisé par le fait que l'âme en forme d'U est orientée vers le listeau de raccord (11) avec son côté ouvert et que l'âme de raccord (15) est formée au côté extérieur de la partie du milieu (18) de cette âme en forme d'U.

7. Dispositif selon une des revendications 1 à 6, caractérisé par le fait que l'âme de raccord (15) est munie d'une rainure de logement (16) pour des pièces ajoutées de support (23) des pièces coulissantes (21), au moins sur une face latérale, arrangée parallèlement au front de l'armoire de distribution.

8. Dispositif selon une des revendications 1 à 7, caractérisé par le fait

que les pièces coulissantes (21) consistent de deux parties en forme de panneau, dont l'une partie est munie du logement de filetage (25) et l'autre partie est munie d'une forure (27) pour la vis de fixation, que, au moyen de la vis de fixation, le panneau de front du châssis équipes peut être joint aux deux parties de la pièce coulissante (21) qui entourent l'âme de raccord (15), et

que, à cette occasion, les deux parties de la pièce coulissante (21) peuvent être fixées simultanément à l'âme de raccord (15), à l'occasion de quoi la pièce ajoutée de support (23) de l'une partie de la pièce coulissante (21) la tient ferme à l'âme de raccord (15) de manière qu'elle ne peut pas être éloignée.

9. Dispositif selon une des revendications 1 à 7, caractérisé par le fait

que les pièces coulissantes (21) sommes formées comme des parties enfichables en forme d'U, à l'occasion de quoi la fente enfichable (26) est montée perpendiculairement sur le logement de filetage (25), qui est mise en place dans un côté (24), et l'autre côté (22) est muni d'une forure en alignement (27) pour la vis de fixation.

10. Dispositif selon revendication 9, caractérisé par le fait

qu'un côté (27) de la partie enfichable est élastique et qu'il porte sur sur son côté intérieur la pièce ajoutée de support (23) pour s'engrèner dans la rainure de logement (16) de l'âme de raccord (15).

11. Dispositif selon une des revendications 1 à 10, caractérisé par le fait

que l'arête longitudinale du listeau de raccord (11) qui est détournée de la bride (12) se termine par une autre âme de raccord (28), qui est montée perpendiculairement sur le front de l'armoire de distribution.

12. Dispositif selon revendication 11, caractérisé par le fait

que l'autre âme de raccord (28) est installée à une âme en forme d'U tellement que les pièces coulissantes (29), qui sont attachées et fixées, se terminent à surface plane avec le côté intérieur qui se tourne vers l'autre listeau de raccord (11).

13. Dispositif selon une des revendications 1 à 12, caractérisé par le fait

que l'âme de raccord (15) qui est reliée avec l'âme en forme d'U est placée vers l'intérieur de l'armoire tellement que le panneau de front (30) du châssis équipes se termine à surface plane avec le côté (17) adjacent de l'âme en forme d'U, qui est muni d'un palier pour le panneau de front (30).